Europäisches Patentamt

European Patent Office

Office européen des brevets

(11) Veröffentlichungsnummer: **0 326 858 B1**

(12) **EUROPÄISCHE PATENTSCHRIFT**

(45) Veröffentlichungstag der Patentschrift: **07.10.92**

(21) Anmeldenummer: **89100812.0**

(22) Anmeldetag: **18.01.89**

(51) Int. Cl.⁵: **G01R 31/28**, G04F 10/00, G01R 31/308

(54) **Verfahren und Anordnung zur Aufzeichnung periodischer Signale mit einer Lasersonde.**

(30) Priorität: **28.01.88 DE 3802566**

(43) Veröffentlichungstag der Anmeldung:
**09.08.89 Patentblatt 89/32**

(45) Bekanntmachung des Hinweises auf die
Patenterteilung:
**07.10.92 Patentblatt 92/41**

(84) Benannte Vertragsstaaten:
**DE FR GB IT NL**

(56) Entgegenhaltungen:
**EP-A- 0 107 040**
**EP-A- 0 180 780**
**WO-A-87/07028**

**APPLIED PHYSICS LETTERS, Band 49, Nr. 6,
11. August 1986, Seiten 357-359, American
Institute of Physics; R.B. MARCUS et al.:
"High-speed electrical sampling by fs photoemission"**

**IEEE JOURNAL OF OUANTUM ELECTRONICS,
Band OE-22, Nr. 1, Januar 1986, Seiten 69-78,
IEEE, New York, US; J.A. VALDMANIS et al.:
"Subpicosecond electrooptic sampling:**

**Principles and applications"**

**APPLIED PHYSICS LETTERS, Band 50, Nr. 19,
11. Mai 1987, Seiten 1310-1312, American Institute of Physics, New York, NY, US; J.M.
WIESENFELD et al.: "Electro-optic sampling
measurements of high-speed InP integrated
circuits"**

(73) Patentinhaber: **SIEMENS AKTIENGESELL-
SCHAFT
Wittelsbacherplatz 2
W-8000 München 2(DE)**

(72) Erfinder: **Brust, Hans-Detlef
Martin-Luther-Strasse 2
W-6602 Dudweiler(DE)**

EP 0 326 858 B1

Rank Xerox (UK) Business Services

## Beschreibung

Die Erfindung bezieht sich auf ein Verfahren zur Aufzeichnung periodischer Signale mit einer Lasersonde nach dem Oberbegriff des Patentanspruchs 1 sowie auf eine Anordnung zur Durchführung des Verfahrens.

Ein solches Verfahren ist beispielsweise aus Microelectronic Engineering Vol. 5 (1986) S. 547-553 und aus der europäischen Offenlegungsschrift 0 180 780 A1 bekannt.

In der Elektronenstrahlmeßtechnik werden stroboskopische Verfahren zur Aufzeichnung und/oder Abbildung schneller periodischer Vorgänge in Bauelementen der Mikroelektronik eingesetzt (siehe beispielsweise Microelectronic Engineering, Vol. 4, No. 2, S. 77-106). Wie bei allen den Stroboskopieeffekt ausnutzenden Verfahren, muß man auch hier die aus einem modifizierten Rasterelektronenmikroskop und einer umfangreichen Elektronik bestehende Meßanordnung mit dem in dem zu untersuchenden Bauelement angeregten Vorgang synchronisieren. Aus der Schaltung oder deren Ansteuerung leitet man deshalb ein mit dem aufzuzeichnenden Vorgang synchrones Triggersignal ab, das den Eintastzeitpunkt des Elektronenstrahls steuert. Die Übertragung der aus der Elektronenstrahlmeßtechnik bekannten Verfahren und Methoden auf die Lasermeßtechnik (siehe beispielsweise IEEE Journ. of Quantum Electronics, Vol. 22, No. 1, S. 69-78), mit der sich eine höhere Zeitauflösung erreichen ließe, stößt unabhängig von den jeweils ausgenutzten Wechselwirkungen und Effekten (Erzeugung von Photoelektronen, Drehung der Polarisationsebene in elektrooptischen Kristallen usw.) auf erhebliche Schwierigkeiten, da sich kurze Laserimpulse nur sehr schwer auf ein Triggersignal hin erzeugen lassen. Es wird deshalb versucht, das Bauelement mit der Meßanordnung zu synchronisieren, indem man den Bausteintakt beispielsweise aus der Impulswiederholfrequenz des Lasers ableitet. Diese Art der Synchronisation erfordert insbesondere dann einen hohen apparativen Aufwand, wenn die Taktfrequenz oberhalb der Impulswiederholfrequenz des Lasers liegt.

Der Erfindung liegt die Aufgabe zugrunde, ein Verfahren der eingangs genannten Art anzugeben, das keine Synchronisation der Meßanordnung und der untersuchten Probe erfordert. Außerdem soll eine Anordnung zur Durchführung des Verfahrens angegeben werden. Diese Aufgabe wird erfindungsgemäß durch ein Verfahren nach Patentanspruch 1 sowie durch eine Anordnung nach Patentanspruch 6 gelöst.

Während die Ansprüche 2 bis 5 vorteilhafte Ausgestaltungen des erfindungsgemäßen Verfahrens betreffen, sind die Ansprüche 7 bis 11 auf Weiterbildungen der Anordnung zur Durchführung des Verfahrens gerichtet.

Der mit der Erfindung erzielbare Vorteil besteht insbesondere darin, daß auch Signale in Bauelementen mit asynchron arbeitenden Schaltungsteilen aufgezeichnet werden können.

Die Erfindung wird nachfolgend anhand der Zeichnungen näher erläutert.

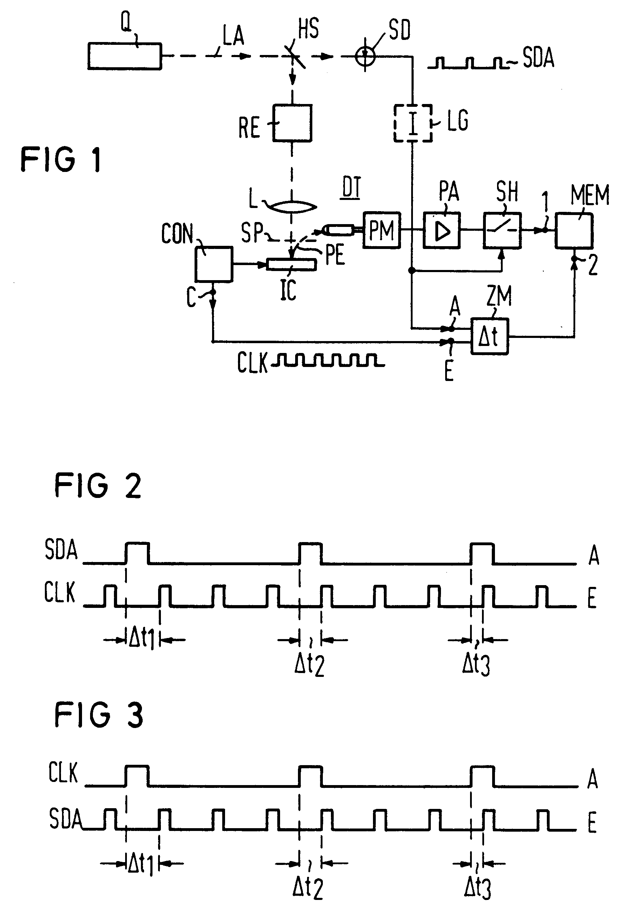

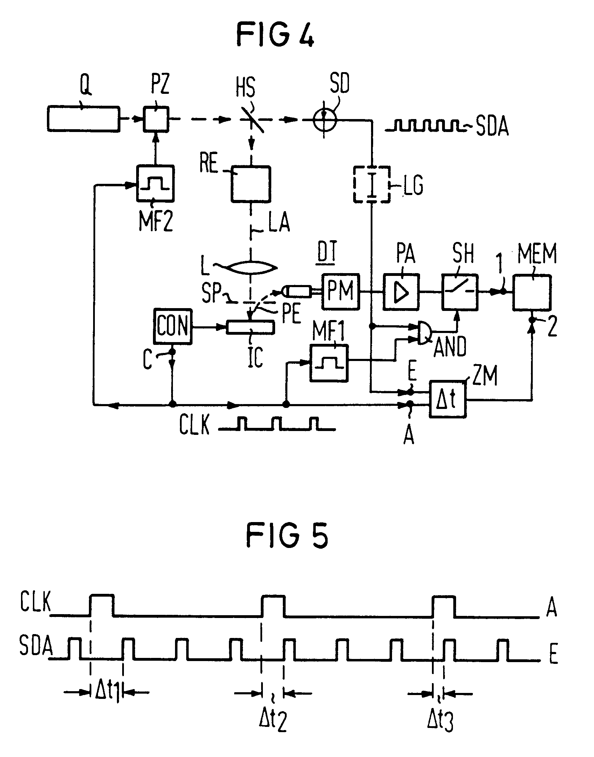

Hierbei zeigen die FIG 1 und 4 Ausführungsbeispiele erfindungsgemäßer Anordnungen und die FIG 2, 3 und 5 die für eine Zeitmessung relevanten Signale.

Die in FIG. 1 schematisch dargestellte Anordnung zur Aufzeichnung eines periodischen Signals in einer Probe IC, umfaßt ein Raster-Laser-Mikroskop, einen Detektor DT zum Nachweis der auf der Probe IC ausgelösten Photoelektronen PE und eine Meßelektronik, der eine Speichereinheit MEM nachgeschaltet ist. Als Strahlungsquelle Q kommt insbesondere das aus der europäischen Offenlegungsschrift 0 180 780 bekannte Lasersystem in Betracht, dessen gepulster Strahl LA (Impulswiederholfrequenz 5 bis 10 MHz, Pulsbreite 1 bis 2 ps, Photonenenergie $\geq$ 5 eV) an einem halbdurchlässigen Spiegel HS umgelenkt und mit Hilfe einer Optik L auf die Probe IC fokussiert wird. Zur Positionierung des Laserstrahls LA auf einem beliebigen Punkt der Probenoberfläche ist eine beispielsweise aus zwei um orthogonale Achsen drehbaren Galvanometerspiegeln bestehende Ablenkeinheit RE vorgesehen, die man vorzugsweise mit einem in FIG 1 nicht dargestellten digitalen Rastergenerator ansteuert. Der seitlich oberhalb der Probe IC angeordnete Detektor DT, dem zur quantitativen Potentialmessung noch ein Spektrometer SP, vorzugsweise ein Gegenfeldspektrometer, vorgelagert sein kann, besteht im wesentlichen aus einer Absaugelektrode, einem Szintillator, einem Lichtleiter und einem Photomultiplier PM, der die im Szintillator erzeugte Strahlungsintensität in ein elektrisches Signal umwandelt. Dieses Signal wird in einem empfindlichen Vorverstärker PA verstärkt und dem Eingang einer Torschaltung SH, insbesondere einer Sample and Hold-Schaltung, zugeführt, deren Ausgang mit dem Dateneingang 1 der Speichereinheit MEM verbunden ist. Als Probe IC ist insbesondere eine integrierte digitale Schaltung vorgesehen, in die man Testprogramme in Form von Bitmustern über die Ansteuerung CON einspeist. Entsprechend der Schaltungsstruktur treten dann während des Testzyklus charakteristische, den jeweiligen Betriebszustand definierende Signale an Knotenpunkten und Leiterbahnen auf, deren Zeitabhängigkeit mit dem Laserstrahl LA durch Nachweis der auf der Schaltung IC ausgelösten Photoelektronen PE bestimmt und mit den aus Simulationsrechnungen gewonnenen Signalen verglichen werden kann. In Analogie zur Elektronenstrahlmeßtechnik wird hierbei die Abhängigkeit des im Detektor DT registrierten Photoelektronenstroms vom Potential des Meßpunktes ausgenutzt, um die Amplitude des Signals zu den durch die Laserimpulse definierten Zeiten abzutasten. Da keine Synchronisation der Meßanordnung und der Probe IC vorliegt (Impulswiederholfrequenz des Lasers ungleich der Frequenz des Schaltungstakts bzw. ungleich einem Bruchteil oder Vielfachen der Frequenz) tasten aufeinanderfolgende Laserimpulse das Signal an verschiedenen Phasenpunkten innerhalb der Periode ab. Synchron zur Abtastung des Signals wird auch jeweils der zugehörige Wert des Photoelektronenstroms mit der Torschaltung SH abgetastet. Um dem Ausgangssignal g(t) der Torschaltung SH den richtigen Zeitpunkt innerhalb der Periode des Signals zuzuordnen, wird der zeitliche Abstand Δt des dem jeweiligen Wert des Ausgangssignals g(t) zugeordneten Laserimpulses zu einem mit dem an dem betreffenden Meßpunkt anliegenden Signal synchronen Triggersignal CLK bestimmt. Als Triggersignal CLK kommt hierbei insbesondere der Schaltungstakt in Betracht, den man am Ausgang C der Ansteuerung CON abgreift und dem Stopp-Eingang E eines Zeitmessers ZM (Tektronix DC 505 A Universal Counter/Timer) zuführt. Das Auftreten eines die Probe IC abtastenden Laserimpulses wird hierbei mit Hilfe eines unmittelbar hinter dem halbdurchlässigen Spiegel HS angeordneten Strahlungsdetektors SD, beispielsweise einer Photodiode, registriert, deren impulsförmiges Ausgangssignal SDA, gegebenenfalls um die Laufzeit der Photoelektronen PE zum Detektor DT verzögert, an Start-Eingang A des Zeitmessers ZM und gleichzeitig auch am Steuereingang der Torschaltung SH anliegt. Das zur Kompensation der Laufzeiteffekte notwendige Verzögerungsglied ist in den FIG 1 und 4 mit LG bezeichnet.

Nach dem Auslösen des Stopp-Signals, wird das der gemessenen Zeitdifferenz Δt entsprechende Ausgangssignal des Zeitmessers ZM über den Dateneingang 2 gleichzeitig mit dem am Dateneingang 1 anliegenden Signalwert g(t) in die Speichereinheit MEM eingelesen. Die dort abgelegten Wertepaare (g(t),Δt) können dann nach Ende der Messung anhand der gemessenen Werte Δt chronologisch geordnet, und auf einer Aufzeichnungseinheit, beispielsweise einem Monitor, dargestellt werden. Zur Verbesserung des Signal-Rausch-Verhältnisses kann man die Meßwerte g(t) vorher gegebenenfalls noch mitteln.

Bisher wurde angenommen, daß die Frequenz des Bausteintaktes CLK größer als die Impulswiederholfrequenz des Lasers ist (siehe FIG 2). Sollte dies nicht der Fall sein, d. h. ist die Impulswiederholfrequenz des Lasers größer als die Frequenz des Bausteintaktes CLK (siehe FIG 3 und 5), so müssen die Eingänge A und E des Zeitmessers ZM vertauscht werden (CLK am Eingang A, SDA am Eingang E). Aufgrund der Ansteuerung der Torschaltung SH durch das Signal SDA und der hohen Impulswiederholfrequenz des Lasers LA werden dann allerdings sehr viele Meßwerte g(t) in die Speichereinheit MEM eingelesen, ohne daß ein entsprechendes Ausgangssignal des Zeitmessers ZM am Dateneingang 2 anliegt. Da die chronologische Ordnung der Meßwerte g(t) nur mit Hilfe der Zeitmeßwerte Δt möglich ist, können Wertepaare der Form (g(t),-) nicht bei der Auswertung berücksichtigt werden. Verwertbar ist demzufolge nur ein kleiner Teil der in der Speichereinheit MEM abgelegten Daten. Es ist deshalb von Vorteil, den Wert des Meßsignals g(t) nur dann abzuspeichern, wenn auch ein Triggersignal CLK vorliegt. Erfindungsgemäß wird dies dadurch erreicht, daß man die Anordnung nach FIG 1 um eine aus einem ausgangsseitig mit dem Steuereingang der Torschaltung SH verbundenes UND-Gatter AND und einem eingangsseitig mit dem Triggersignal CLK beaufschlagten Monoflop MF1 bestehenden Schaltungsteil erweitert (siehe FIG 4). Die Zeitkonstante des Monoflops MF1 wird hierbei so gewählt, daß sie kleiner als der zeitliche Abstand aufeinanderfolgender Laserimpulse ist. Durch diese Vorgabe der Zeitkonstante ist sichergestellt, daß nur der dem Triggersignal CLK zeitlich unmittelbar folgende Laserimpuls (repräsentiert durch das zeitgleich auftretende Signal SDA an Eingang des Gatters AND) die Torschaltung SH aktiviert.

Zur Reduktion der Probenbelastung durch den Laserstrahl LA kann die Messung auf ein insbesondere einstellbares Zeitfenster beschränkt werden, zu Beginn dessen das Triggersignal CLK auftritt. Das am Ausgang C der Ansteuerung CON abgreifbare Triggersignal CLK wird deshalb auch dem Eingang eines einstellbaren Monoflops MF2 zugeführt, dessen Ausgangssignal ein im Strahlengang des Raster-Laser-Mikroskops angeordnetes Schaltelement PZ, beispielsweise eine Pockelszelle, ansteuert. Das Schaltelement PZ ist nicht notwendig, wenn der Laser Q selbst geschaltet werden kann (Q-Switching). In diesem Fall ist der Ausgang des Monoflops MF2 direkt mit dem entsprechenden Steuereingang des Lasers Q verbunden.

Die Erfindung ist selbstverständlich nicht auf die beschriebenen Ausführungsbeispiele beschränkt. So kann anstelle des Bausteintaktes jedes zu dem aufzuzeichnenden Vorgang synchrone Signal, also beispielsweise auch ein anderes internes Signal der integrierten Schaltung IC, als Triggersignal CLK verwendet werden. Das erfindungsgemäße Verfahren ist deshalb insbesondere für die Untersuchung integrierter Bauelemente mit asynchron arbeitenden Schaltungsteilen geeignet, bei denen das Triggersignal CLK nicht an der Ansteuerung CON abgegriffen werden kann.

Anstelle der Photoelektronen PE kann selbstverständlich auch der induzierte Probenstrom (Optical Beam Induced Current) gemessen und aufgezeichnet werden. Hierbei erzeugt der Laserstrahl LA in der integrierten Schaltung IC Elektron-Loch-Paare, die in der Nähe von pn-Übergängen getrennt werden und dadurch einen an den äußeren Anschlüssen der Schaltung nachweisbaren Strom hervorrufen.

Sollen elektrooptische Effekte zur Aufzeichnung hochfrequenter Signale ausgenutzt werden, so bleibt der Aufbau der anhand der FIG 1 und 2 beschriebenen Meßelektronik unverändert. Anstelle der Photoelektronen muß dann allerdings die Drehung der Polarisationsebene des Laserstrahls in einem elektrooptischen Medium detektiert werden. Das Raster-Laser-Mikroskop ist in diesem Fall beispielsweise mit einem zweiten halbdurchlässigen Spiegel ausgestattet, der die auf der Unterseite eines auf der Schaltung angeordneten elektrooptischen Kristalls reflektierte Laserstrahlung aus dem Strahlengang ausblendet und einer Polarisator-Detektoreinheit zuführt. Der prinzipielle Aufbau einer für diese Messungen geeigneten Apparatur ist dem Fachmann beispielsweise aus IEEE Journ. of Quantum Elektronics, Vol. 22, No. 1, S. 69-78 (siehe insbesondere FIG 2) bekannt.

Die Meßgrößen g(t) und Δt können auch ortsabhängig aufgezeichnet werden, indem man den Laserstrahl LA zeilenförmig über die Probe IC ablenkt und außer dem Wertepaar (g(t),Δt) auch die durch das Ausgangssignal des die Ablenkeinheit RE ansteuernden Rastergenerators definierte Position des Laserstrahls LA auf der Probenoberfläche abspeichert.

Als Speichereinheit MEM kommt insbesondere ein Rechner oder ein schneller Massenspeicher in Betracht.

**Patentansprüche**

1. Verfahren zur Aufzeichnung periodischer Signale mit einer Lasersonde (LA), bei dem die Lasersonde (LA) gepulst und auf mindestens einen ein erstes Signal führenden Punkt einer Probe (IC) gerichtet wird, und bei dem ein durch die Lasersonde (LA) in oder auf der Probe (IC) ausgelöstes Sekundärsignal (PE) registriert und in ein Meßsignal (g(t)) umgewandelt wird, dadurch **gekennzeichnet, daß** die Lasersonde (LA) asynchron eingetastet wird, daß der zeitliche Abstand (Δt) der Impulse der Lasersonde (LA) zu einem mit dem ersten Signal synchronen zweiten Signal (CLK) bestimmt wird und daß der dem jeweiligen Impuls der Lasersonde (LA) zugeordnete Wert des Meßsignals (g(t)) und der gemessene zeitliche Abstand (Δt) des Impulses zum zweiten Signal (CLK) aufgezeichnet wird.

2. Verfahren nach Anspruch 1, dadurch **gekennzeichnet, daß** das Meßsignal (g(t)) aus einem in einem Detektor (DT) gemessenen Sekundärteilchensignal abgeleitet wird.

3. Verfahren nach Anspruch 1, dadurch **gekennzeichnet, daß** das Meßsignal (g(t)) aus dem induzierten Probenstrom abgeleitet wird.

4. Verfahren nach Anspruch 1, dadurch **gekennzeichnet, daß** eine in einem elektrooptischen Medium erzeugte Drehung der Polarisationsebene der Lasersonde (LA) gemessen und hieraus das Meßsignal (g(t)) abgeleitet wird.

5. Verfahren nach einem der Ansprüche 1 bis 4, dadurch **gekennzeichnet, daß** die Lasersonde (LA) über die Probenoberfläche abgelenkt wird und daß die aus der gemessenen Zeitdifferenz (Δt) und dem zugehörigen Wert des Meßsignals (g(t)) bestehenden Wertepaare in Abhängigkeit vom Ort des Lasersonde (LA) auf der Probe (IC) aufgezeichnet werden.

6. Anordnung zur Aufzeichnung periodischer Signale mit einer Lasersonde, mit einer Einrichtung (Q) zur Erzeugung einer gepulsten Lasersonde (LA), mit einem Linsensystem (L) zur Fokussierung der Lasersonde (LA) auf eine Probe (IC), mit einer Einrichtung (RE) zur Positionierung der Lasersonde (LA) auf mindestens einem ein erstes Signal führenden Punkt der Probe (IC), mit einer Einrichtung (DT) zum Nachweis eines auf oder in der Probe (IC) durch die Lasersonde (LA) erzeugten Sekundärsignals (PE), mit einer der Einrichtung (DT) zugeordneten Auswerteelektronik zur Erzeugung eines Meßsignals (g(t)) und mit einer Aufzeichnungseinheit (MEM), **gekennzeichnet** durch eine ausgangsseitig mit der Aufzeichnungseinheit (MEM) verbundenen Einrichtung (ZM) zur Messung einer Zeitdifferenz (Δt), deren erster Eingang (A) mit einem mit dem ersten Signal synchronen zweiten Signal (CLK) beaufschlagt ist und einem, Strahlungsdetektor (SD), dessen Ausgangssignal (SDA) an einem zweiten Eingang (E) der Einrichtung (ZM) zur Messung der Zeitdifferenz (Δt) anliegt.

7. Anordnung nach Anspruch 6, dadurch **gekennzeichnet, daß** die Auswerteelektronik eine Torschaltung (SH) aufweist.

8. Anordnung nach Anspruch 7, **gekennzeichnet** durch eine Sample and Hold-Schaltung (SH) als Torschaltung.

9. Anordnung nach Anspruch 7 oder 8, dadurch **gekennzeichnet,** daß ein Steuereingang der Torschaltung (SH) mit dem Ausgangssignal (SDA) des Strahlungsdetektors (SD) beaufschlagt ist.

10. Anordnung nach einem der Ansprüche 6 bis 8, **gekennzeichnet** durch eine ausgangsseitig mit einem Steuereingang der Torschaltung (SH) verbundenen UND-Gatter (AND) und eine eingangsseitig mit dem zweiten Signal (CLK) beaufschlagte monostabile Kippschaltung (MF1), wobei ein erster Eingang des UND-Gatters (AND) mit dem Ausgangssignal (SDA) des Strahlungsdetektors (SD) und ein zweiter Eingang mit dem Ausgangssignal der monostabilen Kippschaltung (MF1) beaufschlagt ist.

11. Anordnung nach einem der Ansprüche 6 bis 10, **gekennzeichnet** durch eine ausgangsseitig mit einer Vorrichtung (PZ) zur Modulation der Intenstiät der Lasersonde (LA) verbundene zweite monostabile Kippschaltung (MF2), an deren Eingang das zweite Signal (CLK) anliegt.

## Claims

1. Method for recording periodic signals using a laser probe (LA), in which method the laser probe (LA) is pulsed and is directed to at least one point of a specimen (IC), which point conducts a first signal, and in which method a secondary signal (PE) which is initiated by the laser probe (LA) in or on the specimen (IC) is registered and is converted into a measurement signal (g(t)), characterised in that the laser probe (LA) is asynchronously imprinted, in that the temporal spacing ($\triangle$t) of the pulses of the laser probe (LA) from a second signal (CLK) synchronous with the first signal is determined, and in that the value of the measurement signal (g(t)) which is associated with the respective pulse of the laser probe (LA) and the measured temporal spacing ($\triangle$t) of the pulse from the second signal (CLK) are recorded.

2. Method according to Claim 1, characterised in that the measurement signal (g(t)) is derived from a secondary particle signal measured in a detector (DT).

3. Method according to Claim 1, characterised in that the measurement signal (g(t)) is derived from the induced specimen current.

4. Method according to Claim 1, characterised in that a rotation, generated in an electro-optical medium, of the plane of polarisation of the laser probe (LA) is measured, and the measurement signal (g(t)) is derived from this.

5. Method according to one of Claims 1 to 4, characterised in that the laser probe (LA) is deflected over the specimen surface, and in that the pairs of values consisting of the measured time difference ($\triangle$t) and the associated value of the measurement signal (g(t)) are displayed as a function of the location of the laser probe (LA) on the specimen (IC).

6. Apparatus for recording periodic signals using a laser probe, having a device (Q) for the generation of a pulsed laser probe (LA), having a lens system (L) to focus the laser probe (LA) onto a specimen (IC), having a device (RE) for positioning the laser probe (LA) on at least one point of the specimen (IC), which point conducts a first signal, having a device (DT) for detecting a secondary signal (PE) generated on or in the specimen (IC) by the laser probe (LA), having an electronic evaluation system, associated with the device (DT), for generating a measurement signal (g(t)) and having a recording unit (MEM), characterised by a device (ZM), connected on the output side with the recording unit (MEM), for measuring a time difference ($\triangle$t), the first input (A) of which receives a second signal (CLK) synchronous with the first signal, and a radiation detector (SD), the output signal (SDA) of which is applied to a second input (E) of the device (ZM) for measuring the time difference ($\triangle$t).

7. Apparatus according to Claim 6, characterised in that the electronic evaluation system exhibits a gate circuit (SH).

8. Apparatus according to Claim 7, characterised by a sample and hold circuit (SH) as gate circuit.

9. Apparatus according to Claim 7 or 8, characterised in that a control input of the gate circuit (SH) receives the output signal (SDA) of the radiation detector (SD).

10. Apparatus according to one of Claims 6 to 8, characterised by an AND gate (AND) connected on the output side with a control input of the gate circuit (SH) and a monostable flip-flop (MF1) which receives on the input side the second signal (CLK), a first input of the AND gate (AND) receiving the output signal (SDA) of the radiation detector (SD) and a second input receiving the output signal of the monostable flip-flop (MF1).

**11.** Apparatus according to one of Claims 6 to 10, characterised by a second monostable flip-flop (MF2), which is connected on the output side with a device (PZ) for modulating the intensity of the laser probe (LA) and to the input of which flip-flop (MF2) the second signal (CLK) is applied.

**Revendications**

**1.** Procédé pour enregistrer des signaux périodiques avec une sonde laser (LA), selon lequel la sonde laser (LA) est commandée de façon pulsée et est dirigée sur au moins un point, produisant un premier signal, d'un échantillon (IC), et selon lequel un signal secondaire (PE), déclenché par la sonde laser (LA) dans ou sur l'échantillon (IC), est enregistré et converti en un signal de mesure (g(t)), caractérisé par le fait que la sonde laser (LA) est commandée de manière asynchrone, que l'intervalle de temps ($\Delta$t) entre les impulsions de la sonde laser (LA) et un second signal (CLK) synchrone avec le premier signal, est déterminé et que la valeur du signal de mesure (g(t)), associée à l'impulsion respective de la sonde laser (LA), et l'intervalle de temps mesuré ($\Delta$t) entre l'impulsion et le second signal (CLK), est enregistré.

**2.** Procédé suivant la revendication 1, caractérisé par le fait que le signal de mesure (g(t)) est dérivé d'un signal de particules secondaires, mesuré dans un détecteur (DT).

**3.** Procédé suivant la revendication 1, caractérisé par le fait que le signal de mesure (g(t)) est dérivé du courant induit de l'échantillon.

**4.** Procédé suivant la revendication 1, caractérisé par le fait qu'une rotation, produite dans un milieu électrooptique, du plan de polarisation de la sonde laser (LA) est mesurée et qu'un signal de mesure (g(t)) en est dérivé.

**5.** Procédé suivant l'une des revendications 1 à 4, caractérisé par le fait que la sonde laser (LA) est déplacée selon un mouvement de balayage sur la surface de l'échantillon et que les couples de valeurs, qui sont constitués par l'intervalle de temps mesuré ($\Delta$t) et la valeur associée du signal de mesure (g(t)) sont enregistrés en fonction de l'emplacement de la sonde laser (LA) sur l'échantillon (IC).

**6.** Dispositif pour enregistrer des signaux périodiques avec une sonde laser, comportant un dispositif (Q) pour produire une sonde laser pulsée (LA), un système de lentilles (L) servant à focaliser la sonde laser (LA) sur un échantillon (IC), un dispositif (RE) pour positionner la sonde laser (LA) en au moins un point, qui délivre le premier signal, de l'échantillon (IC), un dispositif (DT) pour détecter un signal secondaire (PE) produit sur ou dans l'échantillon (IC) par la sonde laser (LA), un système électronique d'évaluation associé au dispositif (DT) et servant à produire un signal de mesure (g(t)) et une unité d'enregistrement (MEM), caractérisé par un dispositif (ZM), qui est raccordé, côté sortie, à l'unité d'enregistrement (MEM) et sert à mesurer l'intervalle de temps ($\Delta$t) et dont la première entrée (A) est chargée par un second signal (CLK) synchrone avec le premier signal et un détecteur de rayonnement (SD), dont le signal de sortie (SDA) est appliqué à la seconde entrée (E) du dispositif (ZM) servant à mesurer l'intervalle de temps ($\Delta$t).

**7.** Dispositif suivant la revendication 6, caractérisé par le fait que le système électronique d'évaluation possède un circuit de porte (SH).

**8.** Dispositif suivant la revendication 7, caractérisé par un circuit échantillonneur-bloqueur (SH) en tant que circuit de porte.

**9.** Dispositif suivant la revendication 7 ou 8, caractérisé par le fait qu'une entrée de commande du circuit de porte (SH) est chargée par le signal de sortie (SDA) du détecteur de rayonnement (SD).

**10.** Dispositif suivant l'une des revendications 6 à 8, caractérisé par une porte ET (AND), raccordée côté sortie à une entrée de commande du circuit de porte (SH), et un circuit à bascule monostable (MF2) chargé côté entrée par le second signal (CLK), une première entrée de la porte ET (AND) étant chargée par le signal de sortie (SDA) du détecteur du rayonnement (SD) et une seconde sortie étant chargée par le signal de sortie du circuit à bascule monostable (MF2).

**11.** Dispositif suivant l'une des revendications 6 à 10, caractérisé par un second circuit à bascule monostable (MF2), qui est raccordé, côté sortie, à un dispositif (PZ) servant à moduler l'intensité de la sonde laser (LA) et à l'entrée duquel est envoyé le second signal (CLK).

FIG 1

FIG 2

FIG 3

# FIG 4

# FIG 5